# EUROPÄISCHE PATENTSCHRIFT

(11) **EP 2 684 009 B1**
(45) Veröffentlichungstag und Bekanntmachung des Hinweises auf die Patenterteilung: **20.04.2016**
(21) Anmeldenummer: 12712923.7
(22) Anmeldetag: 27.02.2012
(51) Int. Cl.: G01B 7/00, G01D 5/251, G01R 33/04, G21C 7/10, G21C 17/10

(54) **VORRICHTUNG ZUR DETEKTION EINES MAGNETISCH LEITFÄHIGEN OBJEKTES SOWIE STELLUNGSMESSSYSTEM ZUR POSITIONSMESSUNG EINES FÜHRSTABES UND ZUGEHÖRIGES POSITIONSMESSVERFAHREN**
APPARATUS FOR DETECTING A MAGNETICALLY CONDUCTIVE OBJECT AND POSITION MEASURING SYSTEM FOR MEASURING THE POSITION OF A GUIDE ROD AND ASSOCIATED POSITION MEASURING METHOD
DISPOSITIF POUR DÉTECTER UN OBJET MAGNÉTIQUEMENT CONDUCTEUR AINSI QUE SYSTÈME DE MESURE DE POSITION POUR MESURER LA POSITION D'UNE BARRE DE GUIDAGE ET PROCÉDÉ DE MESURE DE POSITION ASSOCIÉ

(30) Priorität: 07.03.2011 DE 102011013270
(43) Veröffentlichungstag der Anmeldung: 15.01.2014
(73) Patentinhaber: AREVA GmbH, 91052 Erlangen (DE)
(72) Erfinder: REYMANN, Markus, 90480 Nürnberg (DE); MUHAMAD ALI, Naeel, 90431 Nürnberg (DE)
(74) Vertreter: Kugler, Jörg
(86) Internationale Anmeldenummer: PCT/EP2012/000835
(87) Internationale Veröffentlichungsnummer: WO 2012/119713

(56) Entgegenhaltungen:
- FR-A2- 2 364 432
- FR-A5- 2 169 437
- US-A- 4 068 163
- US-A- 5 333 160
- US-A1- 2006 056 575
- US-A1- 2009 058 410

## Beschreibung

Die Erfindung betrifft eine Vorrichtung zur Detektion eines ferromagnetischen Objektes sowie ein Stellungsmesssystem zur Messung der Position eines Führstabes, und ein zugehöriges Verfahren zur Messung der Position eines Führstabes, insbesondere eines Steuerstabes oder eines Antriebstabes für einen Steuerstab in einer kerntechnischen Anlage.

In einer kerntechnischen Anlage, beispielsweise in einer Kernkraftwerksanlage, werden linear verfahrbare Steuerstäbe verwendet, um Kettenreaktionen von Kernzerfallsprozessen in einem Reaktor, bei denen Teilchenstrahlung - insbesondere Neutronenstrahlung - emittiert wird, durch Absorption der Strahlung zu kontrollieren. Je weiter solche Steuerstäbe, die typischerweise in Gruppen gebündelt angeordnet sind, zwischen die nuklearen Brennelemente geschoben werden, desto größere Anteile der die Kettenreaktion weiter antreibenden Teilchenstrahlung werden absorbiert, so dass die Kettenreaktion entsprechend langsamer abläuft und bei voller Ausfahrposition der Steuerstäbe zum Erliegen gebracht wird. Zustand und Ablauf der Kettenreaktion sind somit von den Ausfahrpositionen der linear verfahrbaren Steuerstäbe abhängig und sind durch diese bestimmt. Eine genaue Kenntnis dieser Positionen ist somit für eine Regelung des Betriebszustandes und somit insbesondere für die Sicherheit relevant.

Stellungsmesssysteme für Steuerstäbe umfassen in der Regel Messvorrichtungen auf der Basis induktiver Messverfahren oder Messvorrichtungen mit magnetischen Sensoren, insbesondere Reed-Kontakten.

Bei einem induktiven Messverfahren wird in einer Primärspule ein elektromagnetisches Wechselfeld erzeugt und der in einer Sekundärspule durch Induktion erzeugte Wechselstrom gemessen. Durch die Induktivität des an den Spulenpaaren vorbei bewegten Steuerstabes wird der zeitliche Verlauf des Induktionsstromes beeinflusst, wodurch bei geeigneter Anordnung einer Mehrzahl von Spulenpaaren entlang des Verschiebe- bzw. Hubweges die Position des Steuerstabes bestimmbar ist.

Weiterhin sind Stellungsmesssysteme bekannt, bei denen am Steuerstab, beispielsweise am Steuerstabkopf, ein Permanentmagnet befestigt ist, der längs des Hubweges positionierte Reed-Kontakte betätigt. Ein magnetischer Sensor nach Art eines Reed-Kontaktes (auch als Reed-Schaltkontakt oder Reed-Relais bezeichnet) ist dazu ausgebildet, bei der Anwesenheit eines hinreichend starken Magnetfeldes im Messbereich des Sensors mittels magnetisierter elektrischer Leiterzungen einen elektrischen Kontaktschluss auszubilden, der durch einen entsprechenden Stromfluss im Stromkreis des Reed-Kontaktes detektierbar ist. Der Reed-Kontakt wirkt also als magnetfeldabhängiger Schalter. Auf diese Weise können insbesondere stationäre Magnetfelder, deren Feldstärken einen vorgegebenen Schwellwert überschreiten, detektiert werden.

Ein Nachteil der oben beschriebenen Messvorrichtungen ist darin begründet, dass ein auf einem Steuerstab angeordneter Permanentmagnet den in einem Reaktorkühlmedium vorherrschenden hohen Temperaturen ausgesetzt ist, wodurch Degradationsprozesse der Magnetisierung und des Materials des Permanentmagneten schneller ablaufen als in einer Umgebung, in welcher weniger extreme Temperaturbedingungen vorherrschen. Weiterhin ist es nur sehr eingeschränkt möglich, an bestehenden Systemen Permanentmagnete auszutauschen oder entsprechend nachzurüsten. Eine Umgehungslösung besteht darin, einen Permanentmagneten auf einer Antriebsstange eines Steuerstabes anzuordnen anstatt auf dem Steuerstab selbst. Eine derartige Lösung für eine Messvorrichtung mit Reed-Kontaktelementen, welche die Merkmale des Oberbegriffs von Anspruch 1 aufweist, ist beispielsweise aus der US 4.068.163 bekannt. Allerdings bleibt das Problem der Zugänglichkeit und/oder der Nachrüstbarkeit teilweise bestehen. Darüber hinaus ist die Redundanz einer solchen Messvorrichtung auf wenige Reed-Kontaktelemente beschränkt. Dies bedeutet, dass bei einer Mehrzahl von entlang des Hubweges installierten Reed-Kontakten (zur Erreichung einer entsprechenden Ortsauflösung der Stellungsmessung) immer nur derjenige schließt, an dem der Permanentmagnet gerade vorbei wird, dass er aber wieder öffnet, sobald der Steuerstab weiterbewegt wird und sich der Permanentmagnet aus dem Einflussbereich des Reed-Kontaktes entfernt.

Eine erste Aufgabe der Erfindung ist es, eine Messvorrichtung anzugeben, mit der die Position eines Steuerstabes ermittelt werden kann, welche im Zuge einer Nutzung möglichst frei von Degradationsprozessen und somit wartungsarm ist, welche bei einer Einrichtung in ein bestehendes System mit einem möglichst geringfügigen Eingriff in das System auskommt, und welche mit einem möglichst hohen Grad an Redundanz und Messsicherheit ausgebildet und eingerichtet werden kann.

Eine zweite Aufgabe der Erfindung ist es, ein Stellungsmesssystem zur Ermittelung einer Position oder einer Mehrzahl von Positionen eines entlang eines geradlinigen Weges bewegbaren Steuerstabes anzugeben, welches möglichst wartungsarm und zuverlässig ist.

Eine dritte Aufgabe der Erfindung ist es, ein Verfahren zur Bestimmung der Position eines Steuerstabes oder einer Antriebsstange für einen Steuerstab anzugeben, welches möglichst zuverlässig ist.

Die erste Aufgabe wird erfindungsgemäß durch die Merkmale des Anspruchs 1 gelöst. Danach wird eine Vorrichtung zur Detektion eines ferromagnetischen Objektes in einem Detektionsbereich vorgeschlagen, mit einer elektrischen Spule und mit mindestens einem Sensorelement, wobei die Spule zur Ausbildung eines magnetischen Feldes in dem Detektionsbereich eingerichtet ist, und das Sensorelement zur Detektion eines magnetischen Feldes mit einer Feldstärke, deren Betrag einen vordefinierten Schwellwert übersteigt, ausgebildet ist, wobei der Schwellwert höher eingestellt ist als die im Detektionsbereich bei Abwesenheit des magnetisch leitfähigen Objektes vorliegende Feldstärke und niedriger als die dort bei Anwesenheit dieses Objekts vorliegende Feldstärke, und wobei die Spule einen Spulenkern in Form eines Kreisringsegmentes aus einem ferromagnetischen Material umschließt.

Antriebsstangen für Steuerstäbe sind üblicherweise im Wesentlichen aus magnetisch leitfähigen Materialien ausgebildet, jeweils zumeist aus Eisen oder einem eisenhaltigen Werkstoff, beispielsweise Stahl. Zu den magnetisch leitfähigen (permeablen) Stoffen zählen insbesondere Ferromagnetika, deren magnetische Permeabilität µᵣ um zumindest eine Zehnerpotenz größer ist als 1, für Eisen gilt beispielsweise µᵣ > 300. Dringt ein Gegenstand aus einem magnetisch leitfähigen Material in den Bereich eines magnetischen Feldes ein, so ist dort die magnetische Flussdichte des Feldes und mithin das Feld selbst erhöht.

Die Erfindung geht von der Überlegung aus, mit Hilfe einer externen elektrischen Spule ein Magnetfeld bereitzustellen, und die Veränderung, sprich Verstärkung, des magnetischen Feldes, die durch die Anwesenheit eines ferromagnetischen Objektes im Detektionsbereich verursacht ist, mit Hilfe eines Sensorelementes zu erfassen. Hierzu ist der elektrische Strom, der die Spule durchfließt, so eingestellt, dass der Betrag der Feldstärke des erzeugten magnetischen Spulenfeldes noch unterhalb des Schwellwertes liegt, bei welchem das Sensorelement reagiert. Nähert sich ein ferromagnetisches Objekt dem magnetischen Feld, so findet eine Magnetisierung des Objektes statt, die sich zu dem Spulenfeld aufaddiert. Die resultierende magnetische Feldstärke am Ort des Sensorelementes überschreitet den vorgegebenen Schwellwert beim Eindringen des Objektes in den Detektionsbereich, so dass das Sensorelement anspricht.

Durch die Verwendung einer externen Spule entfällt die Notwendigkeit, das zu detektierende Objekt separat zu magnetisieren - beispielsweise durch eine Anbindung eines Permanentmagneten an das Objekt - und das Magnetfeld mit Hilfe eines passiven Sensorsystems zu erfassen.

Mit der erfindungsgemäßen Vorrichtung kann das Magnetfeld, welches durch die Spule erzeugt wird, variabel eingestellt und de/aktiviert werden. Hierdurch ist insbesondere eine Nutzung unterschiedlicher Sensorelemente mit unterschiedlichen vordefinierten Schwellwerten in Kombination mit ein und derselben Spule möglich. Weiterhin kann auch eine Mehrzahl von Sensoren mit unterschiedlichen Schwellwerten in Kombination mit ein und derselben Spule genutzt werden, womit zugleich die Redundanz und die Detektionsgenauigkeit der Vorrichtung erhöht ist. Falls bekannt ist, dass sich das Objekt im Detektionsbereich befindet - falls es beispielsweise nach einer bereits stattgefundenen Detektion nicht weiter bewegt wurde - so kann das Spulenfeld auch wieder deaktiviert werden. Mit Hilfe eines Sensorelementes, welches schon auf Magnetfelder mit einer Feldstärke oberhalb eines niedrigeren Schwellwertes anspricht, kann dann gegebenenfalls noch das Remaneszenzfeld des durch das Spulenfeld magnetisierten Objektes erfasst werden, womit das Objekt bei einem deaktivierten Spulenfeld auch passiv noch nachweisbar ist.

Erfindungsgemäß umschließt die Spule einen Spulenkern in Form eines Kreisringsegmentes aus einem ferromagnetischen Material. Durch eine Magnetisierung des Spulenkerns ist das Magnetfeld der Spule verstärkt. Des Weiteren ist die Form eines Kreisringsegmentes, beispielsweise eines Halbkreisringes, in bevorzugter Weise zur Umschließung des Detektionsbereiches geeignet.

Bevorzugterweise ist der Spulenkern im Wesentlichen aus Eisen oder aus einer eisenhaltigen metallischen Legierung gebildet. Eisen ist kostengünstig verfügbar und ferromagnetisch. Eisenhaltige Legierungen können darüber hinaus weitere geeignete Materialeigenschaften aufweisen, welche insbesondere eine höhere Robustheit und Verschleißfestigkeit als bei reinem Eisen bedingen.

In einer bevorzugten Ausführung der Vorrichtung ist ein oder jedes Sensorelement innerhalb des Detektionsbereiches oder zwischen der Spule und dem Detektionsbereich angeordnet. In diesen Bereichen ist die Veränderung des magnetischen Feldes, die durch ein in den Detektionsbereich eindringendes und/oder dort anwesendes Objekt verursacht ist, am deutlichsten ausgeprägt.

In einer besonders geeigneten Ausbildung der Vorrichtung ist das Sensorelement als ein Kontaktsensor, insbesondere als ein Reed-Kontaktelement, gegeben. Ein Reed-Kontaktelement umfasst zwei Kontaktzungen, deren Kern jeweils in der Regel aus einem ferromagnetischen Metall gebildet ist. Ein Magnetfeld im Bereich des Reed-Kontaktelementes führt zu einer Anziehung der beiden Kontaktzungen. Überschreitet die Feldstärke des Magnetfeldes einen Schwellwert, so ist zwischen den beiden Kontaktzungen ein Kontaktschluss ausgebildet, so dass ein elektrischer Steuerstrom über den Kontakt fließen kann. Zur Verbesserung der Leitfähigkeit und zur Verminderung eines vorzeitigen Kontaktschlusses sind die Kontaktzungen üblicherweise mit einem Edelmetall beschichtet, beispielsweise Kupfer oder Silber, und sind in der Regel in einen evakuierten oder mit Schutzgas befüllten Glaskolben eingeschlossen. Reed-Kontaktelemente sind über einen weiten Größenbereich skalierbar und sind robust und kostengünstig verfügbar.

Die zweite Aufgabe wird erfindungsgemäß durch die Merkmale des Anspruchs 5 gelöst. Danach wird ein Stellungsmesssystem zur Messung einer Position oder zur Messung einer Mehrzahl von Positionen eines bezüglich eines Führsystems entlang eines geradlinigen Weges ausgedehnten und entlang des geradlinigen Weges bewegbaren und im Wesentlichen aus einem ferromagnetischen Material ausgebildeten Führstabes vorgeschlagen, mit einer Vorrichtung bzw. mit einer Mehrzahl von Vorrichtungen der oben dargestellten Art gemäß der ersten Aufgabe der Erfindung.

Als Position des Führstabes ist die Lage eines bezüglich des Führstabes stationären Referenzpunktes definiert, wobei der Referenzpunkt bezüglich des geradlinigen Weges genau eine variable Ortskoordinate hat. Vorzugsweise ist der Referenzpunkt am Ort einer Endseite des Führstabes gewählt. Erreicht der Führstab endseitig den Detektionsbereich eines Sensorelementes, und reagiert das Sensorelement daraufhin, so entspricht die Position des Führstabes im Sinne der Definition gerade dem Detektionsbereich des Sensorelementes bezüglich des geradlinigen Weges. Die Position des Führstabes ist bis auf die räumliche Trennungsschärfe - die Auflösung - des Sensorelementes eindeutig bestimmt.

Die spezielle Wahl des Referenzpunktes an einer Endseite des Führstabes stellt keine Beschränkung der Allgemeinheit dar. Bei einer anderen Wahl des Referenzpunktes sind die gemessenen Positionswerte im Vergleich zu den Werten bei der speziellen Wahl des Referenzpunktes um eine konstante Länge verschoben, die durch den Abstand zwischen der Endseite und dem Referenzpunkt entlang des geradlinigen Weges gegeben ist. Nachfolgend ist ohne Einschränkung der Allgemeinheit die Position des Führstabes im Sinne der obigen Definition verwendet.

Zweckmäßigerweise ist oder sind die vom Stellungsmesssystem umfasste Vorrichtung bzw. die umfassten Vorrichtungen gemäß der ersten Aufgabe der Erfindung entlang des geradlinigen Weges angeordnet, wobei die bzw. jede zu messende Position des Führstabes innerhalb des bzw. jeweils innerhalb eines Detektionsbereiches der bzw. einer Vorrichtung lokalisiert ist.

Vorzugsweise ist eine oder jede Spule im Wesentlichen innerhalb eines Bereiches bzw. innerhalb jeweils eines Bereiches um eine zu dem geradlinigen Weg orthogonale Ebene angeordnet. In einer derartigen geometrischen Anordnung gelingt es in bevorzugter Weise, dass der jeweilige Detektionsbereich den geradlinigen Weg vollständig umschließt bei zugleich einem möglichst geringen Volumen des Detektionsbereiches. Je geringer das Volumen eines Detektionsbereiches ist, desto genauer ist die räumliche Trennungsschärfe der Detektion eines magnetisch leitfähigen Objektes, und desto genauer ist die Messung der Position des Führstabes, die in dem Stellungsmesssystem dem Detektionsbereich zugeordnet ist. In einer besonders geeigneten Weiterbildung des Stellungsmesssystems ist insbesondere eine oder eine Mehrzahl von Spulen mit einem bzw. einer Mehrzahl von kreissegmentförmigen Spulenkernen versehen, mit denen der geradlinige Weg kreissegmentförmig umschlossen ist.

In einer bevorzugten Ausführung des Stellungsmesssystems ist eine Mehrzahl von Spulen entlang des Weges gleichmäßig beabstandet zueinander angeordnet. Auf diese Weise sind zueinander äquidistante Positionen des Führstabes messbar.

In einer geeigneten Ausbildung des Stellungsmesssystems ist ein oder jedes Sensorelement mit dem Führsystem verbunden. Insbesondere ist das jeweilige Sensorelement kontaktschlüssig und/oder formschlüssig mit einem linear ausgedehnten, parallel zu dem geradlinigen Weg angeordneten Bauteil des Führsystems verbunden.

In einer speziellen Ausführungsvariante des Stellungsmesssystems ist der Führstab als eine Antriebsstange eines Steuerstabes einer kerntechnischen Anlage gegeben, und das Führsystem umfasst ein die Antriebsstange umschließendes Druckrohr. Die Längsachse des Druckrohres ist hierbei parallel zu dem geradlinigen Weg angeordnet, wobei der Abstand zwischen der Längsachse und dem Weg klein ist im Verhältnis zu dem Durchmesser des Druckrohres. Insbesondere ist in einer derartigen Anordnung ein oder eine Mehrzahl von Sensorelementen mit der nach außen gerichteten Oberfläche des Druckrohres kontaktschlüssig und/oder formschlüssig verbunden. Die Antriebsstange bildet dabei das ferromagnetische Objekt mit vergleichsweise hoher Permeabilität µᵣ » 1, während das Druckrohr nur eine vergleichsweise geringe Permeabilität von beispielsweise µᵣ < 2 besitzt, somit paramagnetische oder leicht diamagnetische Eigenschaften aufweist und für ein vorhandenes Magnetfeld "durchlässig" ist und dieses nur unwesentlich verändert, insbesondere leicht abschwächt.

Bevorzugterweise ist eine Mehrzahl von Spulen in einer Reihenschaltung an eine und dieselbe Spannungsquelle angeschlossen. Insbesondere ist damit die Komplexität der Schaltung und der Verkabelungsaufwand im Stellungsmesssystem im Vergleich zu einer separaten Spannungsversorgung jeder Spule vermindert, oder der Grad der Redundanz des Stellungsmesssystems ist bei einer gleichbleibenden Schaltungskomplexität erhöht.

In einer weiteren, geeigneten Ausbildung des Stellungsmesssystems ist die Spule oder eine Mehrzahl von Spulen mit einer zweiten, entlang des geradlinigen Weges angeordneten Spule, in einer Reihenschaltung verbunden. In einer derartigen Anordnung ist die Spannungsversorgung über einen sekundären Stromkreis, welcher zur Versorgung der zweiten Spule eingerichtet ist, implementiert, womit eine separate Stromversorgung der Spule bzw. Spulen über einen bzw. mehrere Primärstromkreise entfällt. Durch eine solche Anordnung ist die Anzahl der Versorgungsleitungen minimiert, darüber hinaus kann das Stellungsmesssystem im Verbund mit einer weiteren Vorrichtung zur Positionsmessung eines Führstabes, beispielsweise mit einer induktiven Messvorrichtung, betrieben werden.

Die dritte Aufgabe wird erfindungsgemäß durch die Merkmale des Anspruchs 13 gelöst. Danach wird ein Verfahren zur Messung einer Position oder zur Messung einer Mehrzahl von Positionen eines bezüglich eines Führsystems entlang eines geradlinigen Weges ausgedehnten und entlang des geradlinigen Weges bewegbaren und im Wesentlichen aus einem ferromagnetischen Material bestehenden Führstabes mit einem Stellungsmesssystem gemäß der zweiten Aufgabe der Erfindung vorgeschlagen, wobei durch eine oder mehrere Spulen ein elektrischer Strom geleitet wird, wobei das durch den elektrischen Strom in einem bzw. in einer Mehrzahl von Detektionsbereich/en induzierte Magnetfeld durch den Führstab an der Position bzw. an einer Mehrzahl der Positionen verändert wird, und wobei die Veränderung des Magnetfeldes in dem oder den Detektionsbereich/en bei Überschreitung des vordefinierten Schwellwertes oder der vordefinierten Schwellwerte detektiert wird.

In der bisherigen Beschreibung wurde vor allem auf den Fall abgehoben, dass die felderzeugenden Spulen mit Gleichstrom bespeist werden, mithin stationäre Magnetfelder erzeugt werden. In einer alternativen Ausbildung des Verfahrens wird durch eine Spule oder durch eine Mehrzahl von Spulen ein Wechselstrom geleitet. Ein Wechselstrom induziert in der bzw. in jeder Spule ein magnetisches Wechselfeld. Die bisherigen Ausführungen sind weiterhin zutreffend mit dem Unterschied, dass die Feldstärke der magnetischen Felder durch die Amplituden der entsprechenden magnetischen Wechselfeder zu substituieren ist. Das oder jedes Sensorelement liefert dann wie bisher kein Ausgangssignal, wenn die Amplitude des Feldes kleiner ist als der Schwellwert, und ein oszillierendes Ausgangssignal, wenn die die Amplitude des Feldes größer ist als der Schwellwert. Mit anderen Worten erfolgt dann eine Auswertung, ob der Sensorkontakt oszilliert, oder ob er dauerhaft geöffnet ist. Eine derartige Ausbildung des Verfahrens ist geeignet für eine Kombination mit einem zweiten, diversitären Messverfahren, beispielsweise mit einem induktiven Messverfahren, bei welchem die Stromversorgung der Spule/n über die Stromversorgung für das weitere Messverfahren, für welches ein Wechselstrom erforderlich ist, implementiert ist. Durch eine derartige Kombination ist die Redundanz und Zuverlässigkeit erhöht, bei zugleich einer gleichbleibenden Anzahl an Stromversorgungsleitungen, die aus dem Messbereich heraus geführt werden müssen.

Die mit der Erfindung erzielten Vorteile bestehen insbesondere darin, dass durch eine Anzahl von außerhalb eines Druckrohres mit geringer magnetischer Permeabilität angebrachten Reed-Kontakten eine besonders zuverlässige Detektion der Stellung eines in dem Druckrohr geführten Steuerstabes bzw. einer Antriebstange für einen Steuerstab erfolgen kann. Erfindungsgemäß wird das zur Betätigung der Reed-Kontakte vorgesehene Magnetfeld nicht über am Steuerstab bzw. an der Antriebsstange angebrachte Permanentmagneten erzeugt, sondern von einer außerhalb des Druckrohres angebrachten felderzeugenden Spule mit ferromagnetischem Kern, speziell Eisenkern, bereitgestellt. Die Feldstärke ist dabei derart gewählt, dass bei Abwesenheit des ferromagnetischen Steuerstabes bzw. der ferromagnetische Antriebsstrange, die Reed-Kontakte noch nicht ansprechen, also beispielsweise noch geöffnet sind. Sobald das Kopfende des Steuerstabes bzw. der Antriebsstange an dem jeweiligen Reed-Kontakt vorbeigeschoben wird, sorgt deren vergleichsweise hohe Permeabilität für eine Erhöhung des Magnetfeldes im Detektionsbereich dieses Kontaktes, so dass der Reed-Kontakt schließt. Mit anderen Worten: Die Verstärkerwirkung des ferromagnetischen Steuerstabes bzw. der Antriebsstange wird genutzt, um die Stärke des äußeren, elektrisch erzeugten Magnetfeldes zu variieren, wodurch die Positionserkennung des Steuerstabes bzw. der Antriebsstange ermöglicht wird.

Im Gegensatz zu der Variante mit felderzeugenden Permanentmagneten bleibt der Reed-Kontakt geschlossen, wenn der Steuerstab bzw. die Antriebsstange weiter voran geschoben wird, zeigt also zusammen mit den anderen bereits vom Steuerstab- bzw. Antriebsstangenkopf passierten Reed-Kontakten permanent die bislang erreichte Position an (Redundanz der Anzeige).

Da keine Veränderung am Steuerstabkopf bzw. Antriebsstangenkopf vorzunehmen ist, sprich kein Permanentmagnet anzubringen ist, eignet sich das erfindungsgemäße System besonders zur Nachrüstung von Altanlagen.

Das Konzept eignet sich ferner besonders für eine Kombination mit einem induktiven Messverfahren. Bei einem induktiven Messverfahren ist eine Primärspule durch Beaufschlagung mit Wechselstrom zu erregen, so dass ein elektromagnetisches Wechselfeld erzeugt wird. Werden die Erregerspulen des Reed-Kontakt-basierten Messsystems in Reihe mit den Primärspulen des induktiven Messsystems geschaltet, so kann das zur Betätigung der Reed-Kontakte notwendige Magnetfeld in Form eines Wechselfeldes bereits gestellt werden. Anders ausgedrückt erfolgt die Erregung der den Reed-Kontakten zugeordneten Spulen über den Primärspulenstromkreis des induktiven Messsystems. Bei geeigneter Auslegung des Reed-Kontaktes, speziell bei geeignet gewählter Trägheit der Kontaktzungen, entsteht bei eingefahrenem Steuerstab durch die ferromagnetische Felderhöhung ein oszillierendes Ausgangssignal an diesem Kontakt. Es ist dann keine Auswertung auf einen dauerhaft geschlossenen oder geöffneten Kontakt erforderlich, sondern eine Überprüfung, ob der Kontakt oszilliert, oder ob er dauerhaft geöffnet ist, um daraus die gewünschte Positionsaussage abzuleiten.

Des Weiteren können bei einer derartigen Kombination mit einem induktiven Messsystem die Ausgangkontakte des Reed-Relais an den Sekundärspulenstromkreis angeschlossen sein, und die Signalauswertung kann über den Sekundärspulenstromkreis erfolgen, so dass eine mehrfache Verwendung der Signalpfade erfolgt.

Nachfolgend werden verschiedene Ausführungsbeispiele der erfindungsgemäßen Vorrichtung und des erfindungsgemäßen Stellungsmesssystems anhand von Zeichnungen erläutert.

Dabei zeigen jeweils vereinfacht und schematisiert:
- FIG. 1: in einer Querschnittsdarstellung eine Vorrichtung 1 zur Detektion eines magnetisch leitfähigen Objektes,
- FIG. 2: die Vorrichtung nach FIG. 1 mit einem eingeschaltetem elektrischen Strom I und dem damit erzeugten Magnetfeld H,
- FIG. 3: die Vorrichtung nach FIG. 2 mit einem magnetisch leitfähigen Objekt 9 im Detektionsbereich 2,
- FIG. 4: in einer Längsschnittdarstellung ein Stellungsmesssystem 10 zur Messung einer Anzahl von Positionen x₁, x₂, ..., x_{N} eines Führstabes 11,
- FIG. 5: in einer Längsschnittdarstellung ein weiteres Stellungsmesssystem, in dem die Messmethode des Stellungsmesssystems gemäß FIG. 4 mit einer davon verschiedenen Messmethode kombiniert wird, und
- FIG. 6: in einer schematischen Darstellung ein Stellungsmesssystem mit einer Mehrzahl von elektrischen Spulen 3 in einer Reihenschaltung 20 und mit Reed-Kontaktelementen 7.

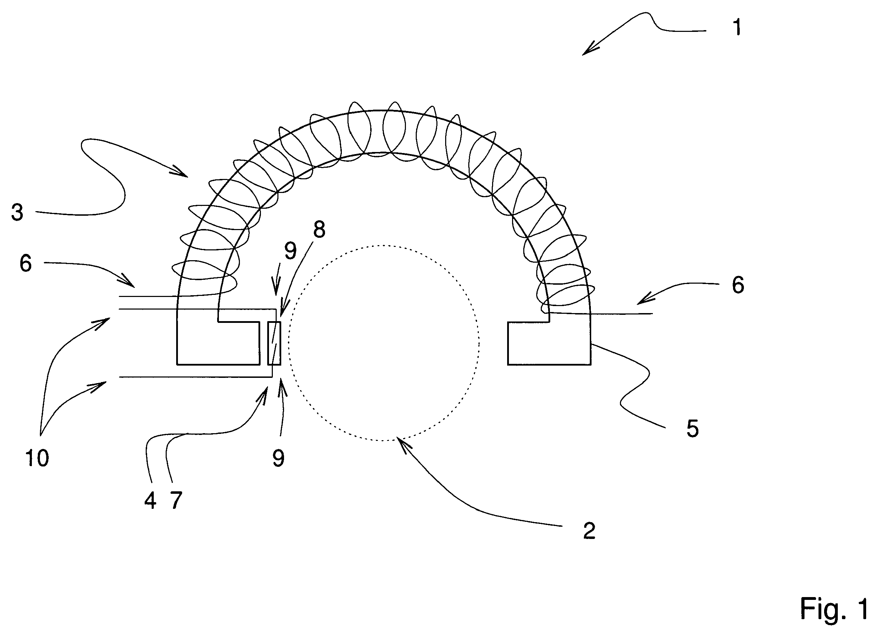

Einander entsprechende Teile in FIG. 1 bis FIG. 6 sind mit identischen Bezugszeichen versehen.

FIG. 1 zeigt in einer Querschnittsdarstellung eine Vorrichtung 1 zur Detektion eines magnetisch leitfähigen Objektes in einem Detektionsbereich 2. Die Vorrichtung 1 umfasst eine elektrische Spule 3 sowie ein Sensorelement 4. Die elektrische Spule 3 ist aus einem um einen Spulenkern 5 gewickelten elektrischen Leiter 6, beispielsweise aus einem isolierten Kupferdraht, ausgebildet. Der halbkreisförmige und den Detektionsbereich 2 einfassende Spulenkern 5 ist aus einem ferromagnetischen Material ausgebildet, beispielsweise aus Eisen. Das Sensorelement 4 ist zwischen dem Detektionsbereich 2 und dem Spulenkern 5 angeordnet, und ist als ein Reed-Kontaktelement 7 ausgebildet, welcher zwei in einem Glaskolben 8 eingeschlossene Kontaktenden 9 aufweist, die jeweils mit einem elektrischen Leiter 10 verbunden sind. Beide Kontaktenden 9 sind aus einem ferromagnetischen Material gebildet.

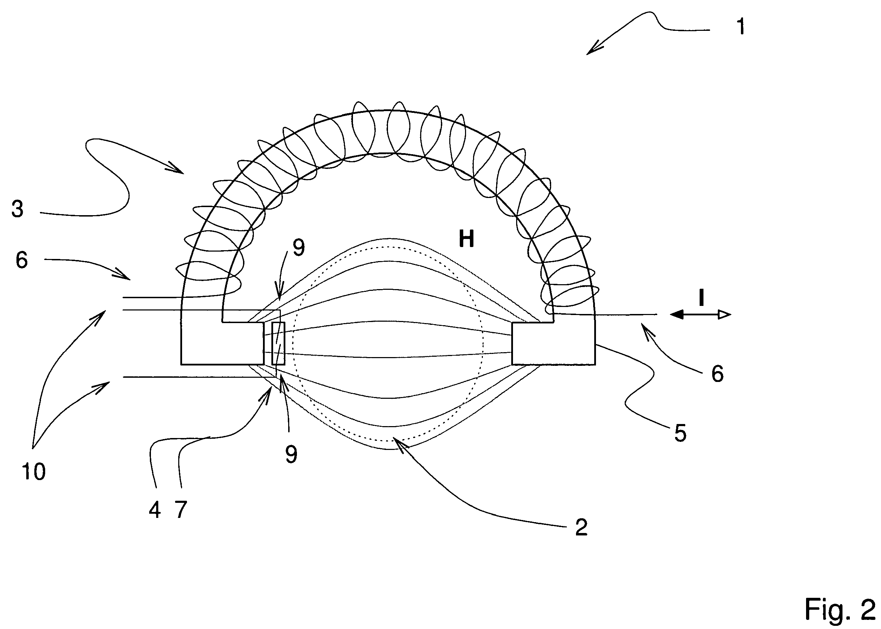

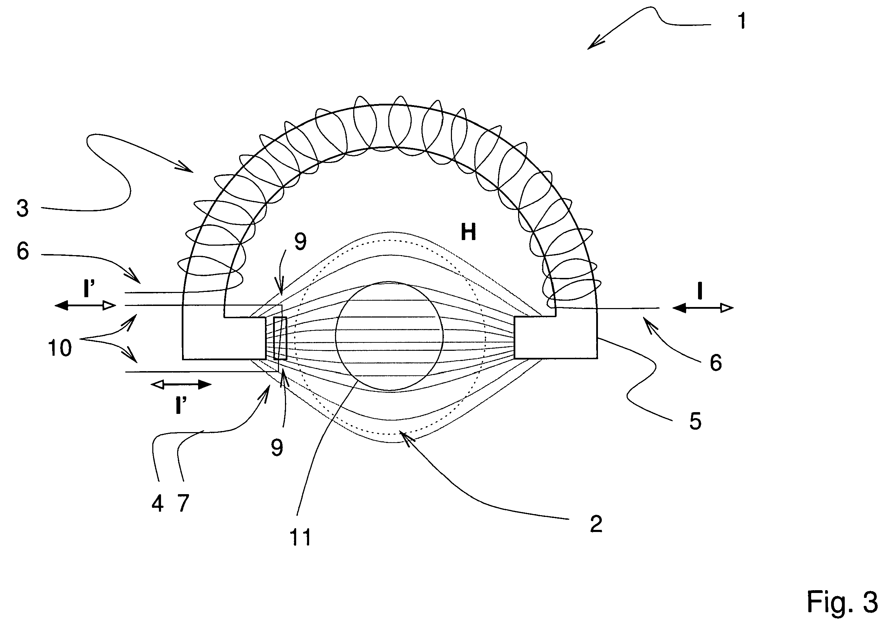

In FIG. 2 ist die Vorrichtung 1 nach FIG. 1 dargestellt, wobei der elektrische Leiter 6 und somit die elektrische Spule 3 von einem elektrischen Strom I durchflossen ist, der das Magnetfeld H erzeugt. Durch den halbkreisförmigen ferromagnetischen Spulenkern 5 ist das Magnetfeld H verstärkt und zwischen den Endseiten des Spulenkerns 5 den Detektionsbereich 2 einfassend ausgebildet, was in der Darstellung an dem Verlauf der Feldlinien des Magnetfeldes H erkennbar ist. Die beiden Kontaktenden 9 des als Reed-Kontaktelement 7 ausgebildeten Sensorelementes 4 sind durch das Magnetfeld H magnetisiert und ziehen sich an. Der Abstand zwischen den Kontaktenden ist durch das Gleichgewicht aus der magnetischen Anziehungskraft zwischen den Kontaktenden 9 und der mechanischen Rückstellkraft bestimmt, wobei die Rückstellkraft in Richtung des neutralen Abstandes zwischen den Kontaktenden 9 wirkt, gemäß FIG. 1. Erst wenn die Feldstärke des Magnetfeldes H am Ort des Sensorelementes 4 einen kritischen Schwellwert erreicht und/oder überschreitet, dann bilden die Kontaktenden 9 einen Kontaktschluss aus, vgl. FIG. 3. In der vorliegenden Darstellung gemäß FIG. 2 ist der elektrische Strom I so eingestellt, dass die Stärke des Magnetfeldes H am Ort des Sensorelementes 4 knapp unterhalb des kritischen Schwellwertes liegt, so dass die beiden Kontaktenden 9 (noch) keinen Kontakt bilden.

In FIG. 3 ist die Vorrichtung 1 nach FIG. 2 dargestellt, wobei ein magnetisch leitfähiges, nämlich ferromagnetisches Objekt 11 im Detektionsbereich 2 angeordnet ist. Das Magnetfeld H durchdringt und magnetisiert das magnetisch leitfähige Objekt 11. Dadurch ist die Feldstärke des Magnetfeldes H vergrößert, insbesondere am Ort des Sensorelementes 4, und der kritische Schwellwert ist überschritten. Die beiden Kontaktenden 9 des Sensorelementes 4 bilden einen Kontaktschluss, so dass durch beide elektrische Leiter 10 ein elektrischer Signalstrom I' fließen kann, der für eine Detektion des magnetisch leitfähigen Objektes 11 im Detektionsbereich 2 kennzeichnend ist.

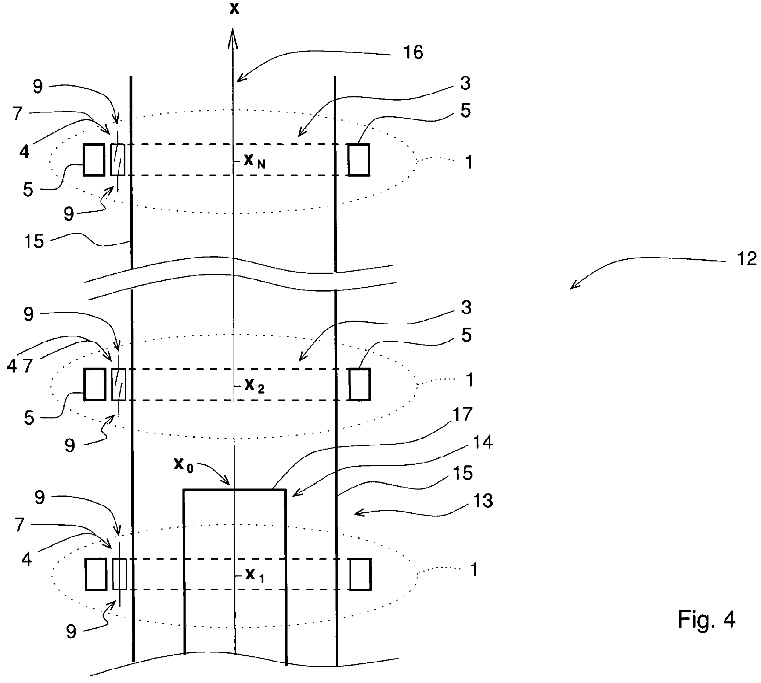

FIG. 4 zeigt in einer Längsschnittdarstellung ein Stellungsmesssystem 12 zur Messung einer Mehrzahl von bezüglich eines Führsystems 13 ortsfesten Positionen x₁, x₂, ... , x_{N} eines bezüglich des Führsystems 13 entlang eines geradlinigen Weges x ausgedehnten und entlang des geradlinigen Weges x bewegbaren und im Wesentlichen aus einem magnetisch leitfähigem Material ausgebildeten Führstabes 14, mit einer Mehrzahl von Vorrichtungen 1 gemäß FIG. 1 bis FIG. 3. Das Führsystem 13 umfasst ein Führungsrohr 15, dessen zentrale Längsachse 16 parallel zu und auf dem Weg x liegt. Die Vorrichtungen 1 sind bezüglich des Weges x gleichmäßig beabstandet zueinander angeordnet, wobei die Ansichtsebenen in FIG. 1 bis FIG. 3 orthogonal zu der zentralen Längsachse 16 und zu dem Weg x jeweils an den Positionen x₁, x₂, ..., x_{N} angeordnet sind. Der Führstab 14 umfasst eine magnetisch leitfähige Antriebsstange 17. Eine Position des Führstabes 14 ist definiert als die Position eines zu dem Führstab 14 ortsfesten Referenzpunktes x₀ bezüglich des Weges x. Der Referenzpunkt x₀ befindet sich an einer Endseite (Kopf- bzw. Stirnfläche) der Antriebsstange 17. Fällt der Referenzpunkt x₀ mit einer der ortsfesten Positionen x₁, x₂, ..., x_{N} zusammen, so hat der Führstab 13 definitionsgemäß die jeweilige Position. An den ortsfesten Positionen x₁, x₂, ..., x_{N} befindet sich jeweils genau eine Vorrichtung 1, in der Darstellung markiert durch den gestrichelten Bereich. Die in dieser Darstellung sichtbaren Komponenten der Vorrichtungen 1 umfassen jeweils die Spule 3 mit Spulenkern 5, sowie das als Reed-Kontaktelement 7 ausgebildete Sensorelement 4 mit den Kontaktenden 9.

Konkret handelt es sich bei dem Führstab 14 beispielsweise um einen Antriebsstab für einen Steuerstab bzw. ein Steuerelement eines Kernreaktors. Der Führstab ist aus einem Material hoher magnetischer Permeabilität µᵣ » 1 gefertigt. Das den Führstab 13 umschließende Führungsrohr 14 bildet ein den Reaktordruckbehälter (nicht dargestellt) des Kernreaktors durchdringendes Druckrohr und ist aus einem Material geringer Permeabilität µᵣ ≈ 1 gefertigt. Entgegen der schematischen Darstellung in FIG. 4 kann der Ringspalt zwischen dem Führstab 13 und dem Führungsrohr 14 schmal gehalten sein.

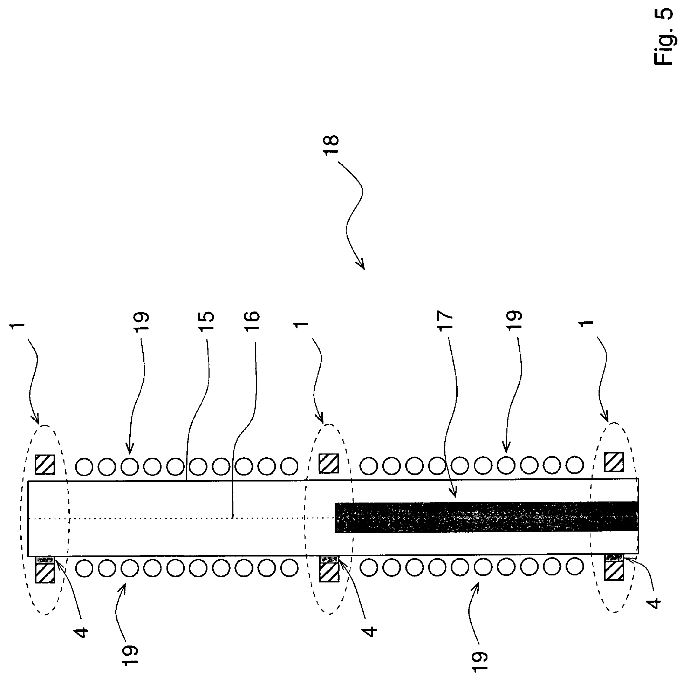

Erreicht die Endseite (das obere Kopfstück) der magnetisch leitfähigen Antriebsstange 17 eine der ortsfesten Positionen x₁, x₂, ..., x_{N}, so wird durch Magnetisierung der Antriebsstange 17 und der daraus resultierenden Feldüberhöhung des Magnetfeldes H und Vergrößerung des magnetischen Flusses im Luftspalt zwischen dem Führungsrohr 14 und dem Spulenkern 5 ein Kontaktschluss in dem Reed-Kontaktelement 9 der Vorrichtung 1, die an der jeweiligen Position x₁, x₂, ..., x_{N} angeordnet ist, gebildet. In dem Moment des Kontaktschlusses ist somit die Position des Führstabes 14 somit bis auf die räumliche Auflösung des Reed-Kontaktelementes 9 eindeutig bekannt. In der vorliegenden Darstellung liegt die Endseite der Antriebsstange 17 mit dem Referenzpunkt x₀ zwischen den ortsfesten Positionen x₁ und x₂. Die Kontaktenden 9 des Reed-Kontaktelementes 7 der Vorrichtung 1 an der Position x₁ sind geschlossen, während die Kontaktenden 9 des Reed-Kontaktelementes 7 der nächst benachbarten Vorrichtung 1 an der Position x₂ offen sind, die Position x₂ ist somit noch nicht erreicht und daher auch noch nicht detektiert. Die Position der Antriebsstange 17 und somit die Position des Führstabes 14 ist also bis auf den Abstand zwischen den benachbarten Positionen x₁ und x₂ bekannt. Die genaue Position kann beispielsweise durch die Messung der Bewegungsgeschwindigkeit und der Bewegungsdauer des Führstabes 14 ermittelt werden, beispielsweise mit Hilfe einer Vorrichtung für ein induktives Messverfahren, vgl. FIG. 5. Wenn der Führstab 14 weiter nach oben geschoben wird, bleibt ein zuvor geschlossenes Reed-Kontaktelement 9 geschlossen (jedenfalls solange das untere Kopfende des Führstabes 14 dieses Reed-Kontaktelement 9 noch nicht passiert hat, was aber in der Praxis aufgrund geeigneter Längendimensionierung und aufgrund der Existenz von Anschlägen nicht vorkommt).

FIG. 5 zeigt in einer Längsschnittdarstellung ein weiteres Stellungsmesssystem 18 mit einer magnetisch leitfähigen Antriebsstange 17, die in einem druckstabilen Führungsrohr 15 entlang der zentralen Längsachse 16 bewegbar ist, mit Vorrichtungen 1 nach FIG. 1 bis FIG. 3, die bezüglich der zentralen Längsachse 16 gleichmäßig beabstandet zueinander angeordnet sind, wobei die Sensorelemente 4 der Vorrichtungen kontaktschlüssig mit dem Führungsrohr 15 verbunden sind. Neben den Vorrichtungen 1, die zusammen mit einer hier nicht dargestellten elektronischen Auswerteeinheit ein erstes Stellungsmesssystem zur Ermittlung der Stellung der Antriebsstange 17 in dem Führungsrohr 15 bilden, ist ein zweites Stellungsmesssystem mit diversitärem Funktionsprinzip, nämlich mit induktivem Funktionsprinzip, vorgesehen. Dieses zweite Stellungsmesssystem umfasst eine Anzahl von weiteren konzentrisch um das Führungsrohr angeordneten Induktionsspulen 19, die als Primärspulen des induktiven Stellungsmesssystems mit Wechselstrom beaufschlagt werden. In bevorzugter Ausgestaltung sind die Induktionsspulen 19 und die Spulen der Reed-Kontakt-basierten Vorrichtungen 1 elektrisch in Reihe geschaltet. Das heißt, auch die Spulen des Reed-Kontakt-basierten Stellungsmesssystems werden mit Wechselstrom beaufschlagt, was bei der Auswertung der Signale der Sensorelemente 4 insofern berücksichtigt wird, als eine Überprüfung stattfindet, ob der jeweilige Reed-Kontakt oszilliert, oder ob er dauerhaft geschlossen ist.

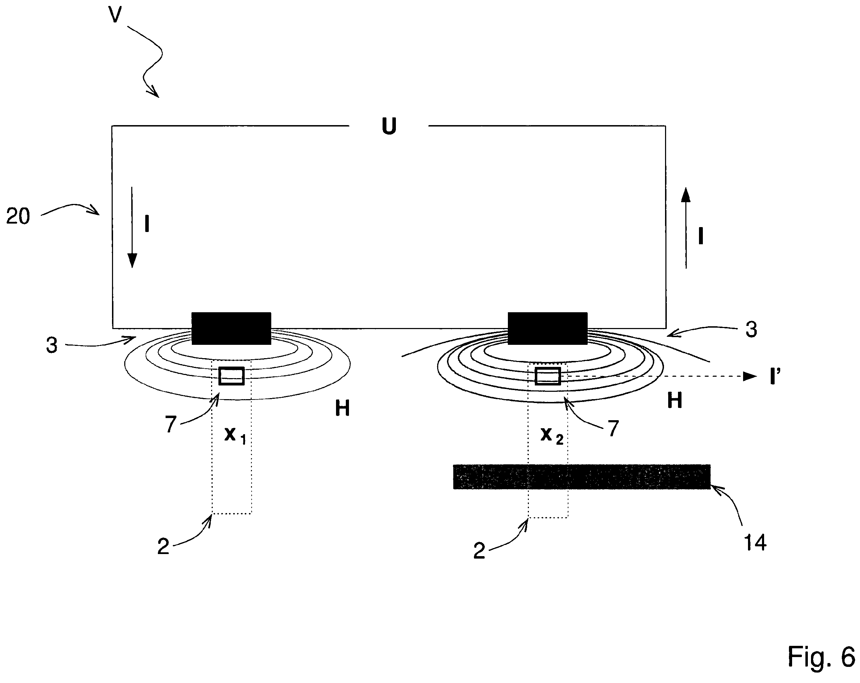

FIG. 6 zeigt in einer schematischen Darstellung eine Reihenschaltung 20 mit zwei elektrischen Spulen 3 und zwei Reed-Kontaktelementen 7. Die Spulen 3 sind den Positionen x₁ und x₂ des Stellungsmesssystems 1 zugeordnet, vgl. FIG. 4. Im Zuge des Verfahrens V wird mit Hilfe der Spannungsquelle U ein elektrischer Strom I in die Reihenschaltung 20 eingespeist. In den Spulen 3 wird im Bereich der Positionen x₁ und x₂ jeweils ein magnetisches Feld H induziert. Der Führstab 14 befindet sich in dem der Position x₂ zugeordneten Detektionsbereich 2 und verstärkt das Magnetfeld H am Ort des korrespondierenden Reed-Kontaktelementes 7. Der Schwellwert dieses Reed-Kontaktelementes 7 ist überschritten, womit durch Kontaktschluss einen Signalstrom I' ausgelöst ist. Der Signalstrom I' kennzeichnet die Detektion des Führstabes 14 im Detektionsbereich 2 des Reed-Kontaktelementes an der Position x₂.

### Bezugszeichenliste

- 1: Vorrichtung
- 2: Detektionsbereich
- 3: elektrische Spule
- 4: Sensorelement
- 5: Spulenkern
- 6: elektrischer Leiter
- 7: Reed-Kontaktelement
- 8: Glaskolben
- 9: Kontaktende
- 10: elektrischer Leiter
- 11: magnetisch leitfähiges Objekt
- 12: Stellungsmesssystem
- 13: Führsystem
- 14: Führstab
- 15: Führungsrohr
- 16: zentrale Längsachse
- 17: Antriebsstange
- 18: Stellungsmesssystem
- 19: Induktionsspule
- 20: Reihenschaltung

- I: elektrischer Strom
- I_{AC}: elektrischer Wechselstrom
- I': elektrischer Signalstrom
- H: magnetisches Feld
- x₁: ortsfeste Position
- x₂: ortsfeste Position
- x_{N}: ortsfeste Position
- x: Weg (geradlinig)
- U: Spannungsquelle

## Patentansprüche

1. Vorrichtung (1) zur Detektion eines ferromagnetischen Objektes (11) in einem Detektionsbereich (2), mit einer elektrischen Spule (3) und mit mindestens einem Sensorelement (4), wobei
• die Spule (3) zur Ausbildung eines magnetischen Feldes (H) in dem Detektionsbereich (2) eingerichtet ist, und
• das Sensorelement (4) zur Detektion eines magnetischen Feldes (H) mit einer Feldstärke, deren Betrag größer ist als ein vordefinierter Schwellwert, ausgebildet ist, und
• der Schwellwert höher eingestellt ist als die im Detektionsbereich (2) bei Abwesenheit des ferromagnetischen Objektes (11) vorliegende Feldstärke und niedriger als die dort bei Anwesenheit dieses Objekts (11) vorliegende Feldstärke,
**dadurch gekennzeichnet, dass** die Spule (3) einen Spulenkern (5) in Form eines Kreisringsegmentes aus einem ferromagnetischen Material umschließt.

2. Vorrichtung (1) nach Anspruch 1, wobei der Spulenkern (5) im Wesentlichen aus Eisen oder aus einer eisenhaltigen metallischen Legierung gebildet ist.

3. Vorrichtung (1) nach einem der Ansprüche 1 bis 2, wobei ein oder jedes Sensorelement (4) innerhalb des Detektionsbereiches (2) oder in einem Bereich zwischen der Spule (3) und dem Detektionsbereich (2) angeordnet ist.

4. Vorrichtung (1) nach einem der Ansprüche 1 bis 3, wobei das Sensorelement (4) als ein Kontaktsensor (7), insbesondere als ein Reed-Kontaktelement (7), gegeben ist.

5. Stellungsmesssystem (12) zur Messung einer Position (x₁) oder zur Messung einer Mehrzahl von Positionen (x₁, ... x_{N}) eines bezüglich eines Führsystems (13) entlang eines geradlinigen Weges (x) ausgedehnten und entlang des geradlinigen Weges (x) bewegbaren und im Wesentlichen aus einem ferromagnetischen Material ausgebildeten Führstabes (14), mit einer Vorrichtung (1) bzw. mit einer Mehrzahl von Vorrichtungen (1) nach einem der Ansprüche 1 bis 4.

6. Stellungsmesssystem (12) nach Anspruch 5, wobei die Position (x₁) oder jede Position (x₁, ... x_{N}) innerhalb des Detektionsbereichs (2) bzw. jeweils innerhalb eines Detektionsbereichs (2) lokalisiert ist.

7. Stellungsmesssystem (12) nach einem der Ansprüche 5 oder 6, wobei eine oder jede Spule (3) im Wesentlichen innerhalb eines Bereiches bzw. innerhalb jeweils eines Bereiches um eine zu dem geradlinigen Weg (x) orthogonale Ebene angeordnet ist.

8. Stellungsmesssystem (12) nach einem der Ansprüche 5 bis 7, wobei eine Mehrzahl von Spulen (4) entlang des Weges (x) gleichmäßig beabstandet zueinander angeordnet sind.

9. Stellungsmesssystem (12) nach einem der Ansprüche 5 bis 8, wobei ein oder jedes Sensorelement (4) mit dem Führsystem (13) verbunden ist.

10. Stellungsmesssystem (12) nach einem der Ansprüche 6 bis 10, wobei
• der Führstab (14) als eine Antriebsstange (17) eines Steuerstabes einer kerntechnischen Anlage gegeben ist, und
• das Führsystem (13) ein die Antriebsstange (17) umschließendes Führungsrohr (15) umfasst.

11. Stellungsmesssystem (12) nach einem der Ansprüche 6 bis 10, wobei eine Mehrzahl von Spulen (3) in einer Reihenschaltung (20) an eine und dieselbe Spannungsquelle (U) angeschlossen sind.

12. Stellungsmesssystem (12) nach einem der Ansprüche 6 bis 11, wobei die Spule (3) oder eine Mehrzahl von Spulen (3) mit einer weiteren, entlang des geradlinigen Weges (x) angeordneten Induktionsspule (19) in einer Reihenschaltung (20) verbunden ist bzw. sind.

13. Verfahren zur Messung einer Position (x₁) oder zur Messung einer Mehrzahl von Positionen (x₁, x₂) eines bezüglich eines Führsystems (13) entlang eines geradlinigen Weges (x) ausgedehnten und entlang des geradlinigen Weges (x) bewegbaren und im Wesentlichen aus einem ferromagnetischen Material bestehenden Führstabes (14) mit einem Stellungsmesssystem (12) nach einem der Ansprüche 7 bis 12, wobei
• durch eine oder mehrere Spulen (3) ein elektrischer Strom (I) geleitet wird,
• das durch den elektrischen Strom (I) in einem bzw. in einer Mehrzahl von Detektionsbereich/en (2) erzeugte Magnetfeld (H) durch den Führstab (14) an der Position (x₁) bzw. an der Mehrzahl der Positionen (x₁, x₂) verändert wird, und
• die Veränderung des Magnetfeldes (H) in dem oder den Detektionsbereich/en (2) bei Überschreitung des vordefinierten Schwellwertes oder der vordefinierten Schwellwerte detektiert wird.

14. Verfahren nach Anspruch 13, wobei durch eine Spule (3) oder durch eine Mehrzahl von Spulen (3) ein elektrischer Wechselstrom (I_{AC}) geleitet wird.

## Claims

1. Device (1) for detecting a ferromagnetic object (11) in a detection region (2), comprising an electrical coil (3) and at least one sensor element (4),
• the coil (3) being arranged to form a magnetic field (H) in the detection region (2), and
• the sensor element (4) being designed to detect a magnetic field (H) having a field strength of which the magnitude is greater than a predefined threshold value, and
• the threshold value being set so as to be higher than the field strength present in the detection region (2) in the absence of the ferromagnetic object (11) and lower than the field strength at this point in the presence of said object (11),
**characterised in that** the coil (3) surrounds a coil core (5) in the form of an annular segment made of a ferromagnetic material.

2. Device (1) according to claim 1, wherein the coil core (5) is made substantially of iron or of an iron-containing metal alloy.

3. Device according to any of claims 1 to 2, wherein one or each sensor element (4) is arranged within the detection region (2) or in a region between the coil (3) and the detection region (2).

4. Device (1) according to any of claims 1 to 3, wherein the sensor element (4) is in the form of a contact sensor (7), in particular a reed contact element (7).

5. Position measuring system (12) for measuring a position (x₁) or for measuring a plurality of positions (x₁, ... x_{N}) of a guide rod (14) which is extended relative to a guide system (13) along a rectilinear path (x), is movable along the rectilinear path (x) and is made substantially of a ferromagnetic material, the position measuring system comprising a device (1) or a plurality of devices (1) according to any of claims 1 to 4.

6. Position measuring system (12) according to claim 5, wherein the position (x₁) or each position (x₁, ... x_{N}) is located within the detection region (2) or located in each case within a detection region (2).

7. Position measuring system (12) according to either claim 5 or claim 6, wherein one or each coil (3) is arranged substantially within a region or arranged in each case within a region about a plane orthogonal to the rectilinear path (x).

8. Position measuring system (12) according to any of claims 5 to 7, wherein a plurality of coils (4) are arranged along the path (x) so as to be evenly spaced apart.

9. Position measuring system (12) according to any of claims 5 to 8, wherein one or each sensor element (4) is connected to the guide system (13).

10. Position measuring system (12) according to any of claims 6 to 10, wherein
• the guide rod (14) is provided as a drive rod (17) of a control rod of a nuclear plant; and
• the guide system (13) has a guide tube (15) surrounding the drive rod (17).

11. Position measuring system (12) according to any of claims 6 to 10, wherein a plurality of coils (3) are connected in a series circuit (20) to the same voltage source (U).

12. Position measuring system (12) according to any of claims 6 to 11, wherein the coil (3) or a plurality of coils (3) is/are connected in a series circuit (20) to a further induction coil (19) arranged along the rectilinear path (x).

13. Method for measuring a position (x₁) or for measuring a plurality of positions (x₁, x₂) of a guide rod (14) which is extended relative to a guide system (13) along a rectilinear path (x), can be moved along the rectilinear path (x) and consists substantially of a ferromagnetic material, the method comprising a position measuring system (12) according to any of claims 7 to 12, wherein
• an electrical current (I) is conducted by one or more coils (3),
• the magnetic field (H) generated by the electrical current (I) in a or in a plurality of detection region(s) (2) is varied by the guide rod (14) at the position (x₁) or at the plurality of positions (x₁, x₂), and
• the variation of the magnetic field (H) in the detection region(s) (2) is detected when the predetermined threshold value(s) is/are exceeded.

14. Method according to claim 13, wherein an alternating electrical current (I_{AC}) is conducted by a coil (3) or a plurality of coils (3).

## Revendications

1. Dispositif (1) de détection d'un objet ferromagnétique (11) dans une zone de détection (2), avec une bobine (3) électrique et avec au moins un élément de capteur (4), dans lequel
• la bobine (3) est aménagée pour la constitution d'un champ magnétique (H) dans la zone de détection (2), et
• l'élément de capteur (4) est constitué pour la détection d'un champ magnétique (H) avec une intensité de champ dont la valeur est supérieure à une valeur de seuil prédéfinie, et
• la valeur de seuil est réglée à une valeur plus élevée que l'intensité de champ régnant dans la zone de détection (2) en l'absence de l'objet ferromagnétique (11) et à une valeur plus basse que l'intensité de champ qui y règne en présence de cet objet (11),
**caractérisé en ce que** la bobine (3) englobe un noyau de bobine (5) sous la forme d'un segment de couronne en matériau ferromagnétique.

2. Dispositif (1) selon la revendication 1, dans lequel le noyau de bobine (5) est formé essentiellement de fer ou d'un alliage métallique contenant du fer.

3. Dispositif (1) selon l'une des revendications 1 à 2, dans lequel un ou chaque élément de capteur (4) est disposé à l'intérieur de la zone de détection (2) ou dans une zone entre la bobine (3) et la zone de détection (2).

4. Dispositif (1) selon l'une des revendications 1 à 3, dans lequel l'élément de capteur (4) est donné en tant que capteur de contact (7), en particulier en tant qu'élément de contact reed (7).

5. Système de mesure de position (12) pour la mesure d'une position (x₁) ou pour la mesure d'une pluralité de positions (x₁, ..., x_{N}) d'une barre de guidage (14) étendue par rapport à un système de guidage (13) le long d'un chemin rectiligne (x) et mobile le long du chemin rectiligne (x) et constituée essentiellement en matériau ferromagnétique, avec un dispositif (1) ou respectivement avec une pluralité de dispositifs (1) selon l'une des revendications 1 à 4.

6. Système de mesure de position (12) selon la revendication 5, dans lequel la position (x₁) ou chaque position (x₁, ..., x_{N}) est localisée à l'intérieur de la zone de détection (2) ou respectivement à l'intérieur d'une zone de détection (2) respectivement.

7. Système de mesure de position (12) selon l'une des revendications 5 ou 6, dans lequel une ou chaque bobine (3) est disposée essentiellement à l'intérieur d'une zone ou respectivement à l'intérieur respectivement d'une zone autour d'un plan orthogonal au chemin rectiligne (x).

8. Système de mesure de position (12) selon l'une des revendications 5 à 7, dans lequel une pluralité de bobines (4) sont disposées le long du chemin (x) avec une distance uniforme entre elles.

9. Système de mesure de position (12) selon l'une des revendications 5 à 8, dans lequel un ou chaque élément de capteur (4) est raccordé au système de guidage (13).

10. Système de mesure de position (12) selon l'une des revendications 6 à 10, dans lequel
• la barre de guidage (14) est donnée en tant que tige d'entraînement (17) d'une barre de commande d'une installation nucléaire, et
• le système de guidage (13) comprend un tube de guidage (15) entourant la tige d'entraînement (17).

11. Système de mesure de position (12) selon l'une des revendications 6 à 10, dans lequel une pluralité de bobines (3) sont connectées dans un montage en série (20) à une seule et même source de tension (U).

12. Système de mesure de position (12) selon l'une des revendications 6 à 11, dans lequel la bobine (3) ou une pluralité de bobines (3) est ou respectivement sont raccordée(s) dans un montage en série (20) à une autre bobine d'induction (19) disposée le long du chemin rectiligne (x).

13. Procédé de mesure d'une position (x₁) ou de mesure d'une pluralité de positions (x₁, x₂) d'une barre de guidage (14) étendue par rapport à un système de guidage (13) le long d'un chemin rectiligne (x) et mobile le long du chemin rectiligne (x) et constituée essentiellement en matériau ferromagnétique, avec un système de mesure de position (12) selon l'une des revendications 7 à 12, dans lequel
• un courant électrique (I) est conduit par une ou plusieurs bobines (3),
• le champ magnétique (H) produit par le courant électrique (I) dans une zone de détection ou respectivement dans une pluralité de zones de détection (2) est modifié par la barre de guidage (14) sur la position (x₁) ou respectivement sur la pluralité de positions (x₁, x₂), et
• la modification du champ magnétique (H) dans la zone de détection ou les zones de détection (2) est détectée lors du passage au-dessus de la valeur de seuil prédéfinie ou des valeurs de seuil prédéfinies.

14. Procédé selon la revendication 13, dans lequel un courant alternatif électrique (I_{AC}) est conduit par une bobine (3) ou par une pluralité de bobines (3).
